Europäisches Patentamt

European Patent Office

Office européen des brevets

⑩

(11) Publication number:

**0 098 079**
**B1**

## (12) EUROPEAN PATENT SPECIFICATION

(45) Date of publication of patent specification: **16.08.90**

(21) Application number: **83303463.0**

(22) Date of filing: **15.06.83**

(51) Int. Cl.⁵: **G 06 F 11/20**

(54) **Semiconductor memory device with redundancy decoder circuit.**

(30) Priority: **30.06.82 JP 111522/82**

(43) Date of publication of application:
**11.01.84 Bulletin 84/02**

(45) Publication of the grant of the patent:
**16.08.90 Bulletin 90/33**

(84) Designated Contracting States:
**DE FR GB**

(56) References cited:

IBM TECHNICAL DISCLOSURE BULLETIN, vol.
23, no. 8, January 1981, pages 3601-3602, New
York, US; B.F. FITZGERALD et al.: "
Semiconductor memory redundancy at the
module level"

ELECTRONICS INTERNATIONAL, no. 15, July
1981, pages 127-130, New York, US; R. ABBOTT
et al.: " Equipping a line of memories with spare
cells"

(73) Proprietor: **FUJITSU LIMITED**
**1015, Kamikodanaka Nakahara-ku**
**Kawasaki-shi Kanagawa 211 (JP)**

(72) Inventor: **Higuchi, Mitsuo**
**5-13, Yutenji 2-chome Meguro-ku**
**Tokyo 153 (JP)**
Inventor: **Hagihara, Ryoji**
**818, Suge Tama-ku**
**Kawasaki-shi Kanagawa 214 (JP)**

(74) Representative: **Skone James, Robert Edmund**
**et al**
**GILL JENNINGS & EVERY 53-64 Chancery Lane**
**London WC2A 1HN (GB)**

(56) References cited:
**ELECTRONICS INTERNATIONAL, no. 3,**
**February 1982, pages 121-125, New York, US; A.**
**GUPTA et al.: "5-V-only EE-PROM-springboard**
**for autoprogrammable systems"**

Courier Press, Leamington Spa, England.

## Description

The present invention relates to a semiconductor memory device, more particularly to a semiconductor memory device including a redundancy decoder circuit.

A recent trend in semiconductor memory devices is for higher integration. Along with this trend, it has become increasingly uneconomical to have to discard an entire memory due to, for example, a defect in a bit memory cell among the large number of memory cells. Thus, in addition to the memory cell array, 1-bit redundancy memory is usually provided. When an address input specifies a defective memory cell, an address jump takes place to the redundancy bit. Therefore, although the memory cell array includes a defective memory cell it can be used as a normal memory. A decoder circuit is useful for switching the address to the redundancy bit.

Various types of decoder circuits have been put into practical use, such as decoder circuits utilising fuses or read only memories (ROM). The fuses are suitably fused or the content of the ROM's is suitably determined in such a manner as to change the output of the decoder circuit to logic "H" (high) only when an address corresponding to just the redundancy bit cell is received.

IBM Technical Disclosure Bulletin vol. 23, number 8, Jan. 1981 pages 3601—3602 illustrates a circuit for generating a redundant address signal when it is activated by a particular address signal. This disclosure describes the replacement of a conventional fuse by an electrically programmable device such as an MNOS, FAMOS, or other non-volatile device.

In accordance with the present invention a semiconductor memory cells; a memory cell array including a plurality of memory cells; a decoder circuit which accesses a specified one of the memory cells in accordance with an address input; a redundancy cell which is to replace a defective memory cell contained in the memory cell array; and a redundancy decoder circuit which receives the address input and is operative to produce a selection signal for selecting the redundancy memory cell when the received address input specifies the address corresponding to the defective memory cell; and is characterised in that the redundancy decoder circuit includes a plurality of FAMOS transistors of the depletion type which are selected at their sources in correspondence with a pattern of the address input, in that during a write operation a predetermined voltage is applied to the commonly connected control gates and that this voltage in combination with a write voltage applied to the commonly connected drains causes injection of hot electrons into the selected individual floating gates, which electrons store a logical state, and in that during the usual memory access mode a predetermined voltage is applied to the commonly connected control gates so as to produce the selection signal at the commonly connected drains if the applied pattern of address input is identical to the stored logical states.

The redundancy decoder circuit with which the present invention is concerned does not utilise a fuse or ROM, but a floating-gate-avalanche-injection depletion-type metal-oxide semiconductor (FAMOS) transistor. Such a FAMOS transistor is particularly useful for a redundancy decoder circuit when a memory is fabricated as an erasable programmable read only memory (EPROM), in view of the use of common transistor elements for the EPROM and redundancy decoder circuit. This is because an EPROM is usually composed of FAMOS transistors.

The present invention provides a semiconductor memory device including a FAMOS transistor type redundancy decoder circuit suitable for practical use.

Conveniently a voltage of ground level or lower is applied in common to the control gates of the FAMOS transistors during the usual memory access mode.

An example of a semiconductor memory device in accordance with the present invention will now be described and contrasted with a less reliable device with reference to the accompanying drawings, wherein:

Figure 1 is a block diagram of a semiconductor memory device including a redundancy decoder circuit;

Figure 2 is a circuit diagram of a circuit arrangement for realising the redundancy decoder circuit of Figure 1;

Figure 3 is a cross-sectional view of the general structure of a FAMOS transistor; and

Figure 4 is a circuit diagram of an example of a redundancy decoder circuit according to the present invention.

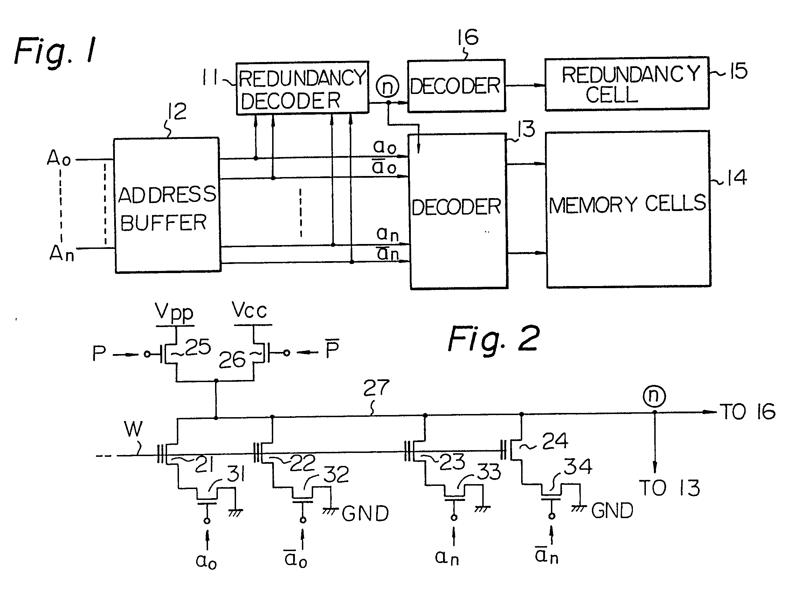

Figure 1 is a block diagram of a semiconductor memory device including a redundancy decoder circuit. In this figure, reference numeral 11 represents a redundancy decoder circuit to which the subject matter of the present invention relates. The redundancy decoder circuit 11 receives an address input which is branched from an input $a_0$, $\bar{a}_0 — a_n$, $\bar{a}_n$ to be applied from an address buffer 12 to a decoder circuit 13. Reference characters $A_0 — A_n$ denote an original address input supplied from, for example, a central processing unit (CPU). The decoder circuit 13 receives the address input $a_0$, $\bar{a}_0 — a_n$, $\bar{a}_n$ and accesses the specified cell among memory cells 14 forming a memory cell array.

As previously mentioned, however, it is impossible to guarantee that all memory cells be manufactured without defective cells. Therefore, if a defective cell exists, its function is replaced by a redundancy cell 15. A decoder circuit cooperating with this redundancy cell 15 is indicated by reference numeral 16 shown in this figure. The decoder circuit 16 or 13 is selectively activated according to whether the address input specifies the defective cell. This activation is determined by a signal appearing at a portion ⓝ, which signal is output from the redundancy decoder circuit 11.

If the address input accesses the defective cell, the address pattern of this input is decoded by the redundancy decoder circuit 11. Then, an ouput of logic "H" (high) appears at the portion ⓝ. This output of the "H" level deactivates the main decoder circuit 13 and activates the redundancy side decoder 16 to select the redundancy cell 15.

Figure 2 is a circuit diagram of an arrangement for realizing the redundancy decoder circuit 11 of Fig. 1. The circuit of Fig. 2 is one by which the inventors tried to realize a FAMOS redundancy decoder. The FAMOS redundancy decoder of Fig. 2, however, is not practical in use. In Fig. 2, reference numerals 21, 22, 23, and 24 represent enhancement type FAMOS transistors. To these FAMOS transistors, data "1" or "0" are written in advance according to an address pattern which corresponds to the address of the defective cell.

During a write mode, a signal P is changed to the "H" level (while a signal $\overline{P}$ is changed to the "L" (low) level). Therefore, a transistor 25 is turned on, while a transistor 26 is turned off. Here, a write voltage $V_{pp}$ of, for example about 20 V appears on a line 27. That is, the high voltage $V_{pp}$ appears at each drain of the FAMOS transistors 21 through 24. At this time, a high voltage of about 20 V is also applied to a word line W. Further, gate transistors 31, 32, 33, and 34 are connected to the FAMOS transistors 21 through 24, at corresponding sources. Thus, only the FAMOS transistors connected to gate transistors which are on are put in a write enable state. If the address pattern corresponding to the defective cell has a pattern of, for example, $(a_0, \overline{a}_0 - a_n, \overline{a}_n) = (1, 0 - 1, 0)$, only the FAMOS transistors 21 and 23 are in the write enable state. That is, hot electrons are injected into each of the write enabled FAMOS transistors, which hot electrons are energized when drain currents flow, due to the high voltage $V_{pp}$, through the write enabled FAMOS transistors. This is because, since the control gates of these FAMOS transistors receive the high voltage supplied via the word line, the hot electrons are attracted to the control gates.

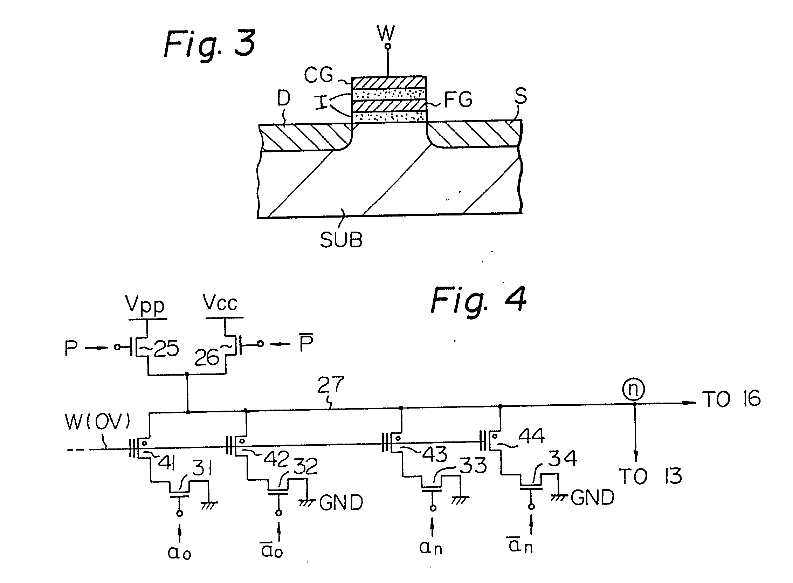

Figure 3 is a cross-sectional view of a general structure of a known FAMOS transistor. In this figure, reference symbols S and D indicate the source and drain, respectively, both formed in a substrate SUB, to which source S one of the gate transistors 31 through 34 in Fig. 2 is connected and to which drain D the line 27 in Fig. 2 is connected. Reference symbol CG indicates the control gate which is connected to the word line W in Fig. 2. A floating gate FG is formed right beneath the control gate CG, which gate FG is sandwiched by insulators I.

Returning to Fig. 2 again, taking the aforementioned case as an example, data are written only in the FAMOS transistors 21 and 23. In other words, the electrons are injected only into the floating gates FG of these FAMOS transistors 21 and 23. Under such circumstance, each threshold level of these FAMOS transistors 21 and 23 increases and then these transistors are transformed into seemingly normally-off transistors.

Thus, the address pattern identical to the address input for the defective cell is written, as a whole, in all the FAMOS transistors 21 through 24. With these written FAMOS transistors a case (when, in Fig. 2, the signal $\overline{P}$ is changed to "H", while the signal P is changed to "L") will be explained below, in which the memory actually achieves the access operation.

During this access operation, if the address input of, for example $(a_0, \overline{a}_0 - a_n, \overline{a}_n) = (1, 0 - 1, 0)$ is supplied, which address input specifies the defective cell, then the gate transistors 31 and 33 are turned on and the gate transistors 32 and 34 are turned off. However, as previously mentioned, the FAMOS transistors 21 and 23 which are connected, respectively to the turn-on gate transistors 31 and 33, have changed to be normally off (it should be understood that about 3 V is now applied to the word line W), and, therefore, the paths between the line 27 and the ground GND are all isolated. As a result, the level of the line 27 increases to the "H" level ($V_{cc}$ level). This "H" level forms the output appearing at the portion ⓝ, which deactivates the decoder circuit 13 and activates the decoder circuit 16. Thus, the redundancy cell 15 is selected.

With the address patterns other than the pattern of $(a_0, \overline{a}_0 - a_n, \overline{a}_n) = (1, 0 - 1, 0)$, at least one of the paths is always conductive. Therefore, the line 27 is maintained at the level of the ground GND. That is, the "L" level output is always given to the portion ⓝ. Thus, the main decoder 13 is activated.

The problem with the redundancy decoder circuit of Fig. 2 resides in its reliability. During the write mode, the write operations are conducted in the FAMOS transistors 21 and 23 according to the prior example. In this case, the write opertion may be unintentionally conducted in any of the FAMOS transistors, other than FAMOS transistors 21 and 23, in which data is not to be written, even with a usual memory access mode other than the write operation mode.

Under such a usual memory access mode, as previously mentioned, each of the FAMOS transistors receives, at its drain D, the voltage $V_{cc}$ (about 5 V) and, at its control gates CG, the voltage of about 3 V supplied via the word line W. Under such conditions, injection of hot electrons into the floating gates FG cannot be guaranteed not to occur.

The reason for this may be considered to be the shortening of channels of the FAMOS transistors. The necessity for a redundancy decoder circuit arises from the high integration of the memory cells. In such highly integrated memory cells, the channel length of each transistor is currently short as about 2 μm. Consequently, there is a considerable chance of erroneous write operations.

With the present invention, a semiconductor memory device is provided including a redundancy decoder circuit which is suitable for practical use, and in which almost all erroneous write operations are prevented.

Figure 4 is a circuit diagram of an example of a redundancy decoder circuit according to the present invention. In Figure 4, members the same as those of Figure 2 are represented by the same reference numerals or symbols. The differences lie in the use of transistors 41, 42, 43, and 44, which are all depletion types FAMOS transistors (depletion-type is symbolized by a small circle in each FAMOS transistor shown in the Figure). In addition, the ground or lower level (in this Figure, referred to as "OV") is applied to the word line W to which the control gates of the transistors 41 through 44 are commonly connected. It should be noted that such OV is applied thereto only during the usual memory access mode. During the write operation, however, a voltage of about 20 V is applied thereto, as in Fig. 2.

The reason for these differences of Fig. 4 compared with Fig. 2 are as follows: Generally, hole and electron pairs are produced at a region close to the drain of each FAMOS transistor. Of the pairs, only the electrons are injected into the floating gate FG so that the write operation is performed therein. In this case, the injection is achieved by attraction of these electrons to the control gate CG having the positive voltage. Therefore, if the control gate CG is maintained, during the usual memory access mode, at the level of the ground or lower, no injection of hot electrons to the floating gate can take place, regardless of whether the hot electrons exist at the region close to the drain. Consequently, under such conditions, no erroneous write operation can be conducted.

Thus, the ground or lower level is applied to the word line W. It is practical to use the voltage of the ground level rather than a lower voltage because the latter level is to be optionally and externally supplied. Now, if a voltage of the ground level is applied to the word line W and if the FAMOS transistors are all made of enhancement type FAMOS transistors as in Fig. 2, the desired operation would not be achieved. That is, in such a case, all the FAMOS transistors would be placed in the normally-off state during the usual memory access model. With thus nonconductive transistors, the level at ⓝ would be charged to about $V_{cc}$ level and, therefore, the main decoder circuit 13, available for the usual memory accessing, would be made nonactive. Accordingly, the FAMOS transistors must be of the depletion type, so that even when the voltage of the ground level is applied to the word line, each FAMOS transistor in which data is written (having the floating gate in which the electrons are injected) is maintained off, while each FAMOS transistor in which no data is written (having no such electron injection) can be maintained on.

This makes it possible to construct a redundancy decoder circuit producing no write error therein, while maintaining the same functions as in the circuit of Fig. 2, by an introduction of the FAMOS transistors 41 through 44 therein.

As explained above, a redundancy decoder circuit which induces no write error can be realized. A a result, the reliability of a semiconductor memory device provided with such a redundancy decoder circuit can be increased.

## Claims

1. A semiconductor memory device comprising a memory cell array including a plurality of memory cells (14); a decoder circuit (13) which accesses a specified one of the memory cells (14) in accordance with an address input; a redundancy cell (15) which is to replace a defective memory cell contained in the memory cell array; and a redundancy decoder circuit (11) which receives the address input and is operative to produce a selection signal for selecting the redundancy memory cell when the received address input specifies the address corresponding to the defective memory cell; characterised in that the redundancy decoder circuit (11) includes a plurality of FAMOS transistors (41—44) of the depletion type which are selected at their sources in correspondence with a pattern of the address input, in that during a write operation a predetermined voltage is applied to the commonly connected control gates and that this voltage in combination with a write voltage applied to the commonly connected drains causes injection of hot electrons into the selected individual floating gates, which electrons store a logical state, and in that during the usual memory access mode a predetermined voltage is applied to the commonly connected control gates so as to produce the selection signal at the commonly connected drains if the applied pattern of address input is identical to the stored logical states.

2. A semiconductor device according to claim 1, wherein the predetermined voltage, for applying to the control gate of each FAMOS transistors during the usual memory access mode, is set to be ground level or lower.

3. A semiconductor device according to claim 1 or claim 2, wherein the depletion-type FAMOS transistors (41—44) are connected at their sources in series with respective gate transistors (31—34), at their one side electrodes, while the other side electrodes of the gate transistors are grounded, the gate electrodes of the gate transistors being arranged to receive the address input so as to make some of the gate transistors conductive and others non-conductive in accordance with the address input.

4. A semiconductor device according to claim 3, wherein the commonly connected drains of the depletion type FAMOS transistors (41—44) receive a write voltage ($V_{pp}$) during the write operation mode, and a power source voltage ($V_{cc}$) during the usual memory access mode at which time the control gates of the depletion type FAMOS transistors receive a voltage having a ground level or lower.

5. A semiconductor device according to claim 4, wherein the write voltage ($V_{pp}$) and the power source voltage ($V_{cc}$) are selectively applied to the commonly connected drains of the depletion type FAMOS transistors (41—44) via a transistor pair (25, 26), one (25) of which is connected to a write voltage source, and the other (26) of which is connected to a power source.

**Patentansprüche**

1. Halbleiterspeichervorrichtung mit einer Speicherzellenanordnung, die eine Vielzahl von Speicherzellen (14) enthält; einer Decoderschaltung (13), welche in Übereinstimmung mit einem Adreßeingang zu einer spezifizierten der Speicherzellen (14) zugreift; einer Redundanzzelle (15), welche eine defekte Speicherzelle ersetzen soll, die in der Speicherzellenanordnung ehthalten ist; und einer Redundanzdecoderschaltung (11), welche den Adreßeingang empfängt und betreibbar ist, um ein Auswahlsignal zur Auswahl der Redundanzspeicherzelle zu erzeugen, wenn der empfangene Adreßeingang die Adresse spezifiziert, welche der defekten Speicherzelle entspricht; dadurch gekennzeichnet, daß die Redundanzdecoderschaltung (11) eine Vielzahl von FAMOS-Transistoren (41—44) vom Verarmungstyp enthält, welche an ihren Sourcen in Übereinstimmung mit einem Muster des Adreßeingangs ansugewählt werden, daß während des Schreibbetriebs eine vorbestimmte Spannung auf die gemeinsam verbundenen Steuergates aufgebracht wird und daß diese Spannung in Kombination mit einer Schreibspannung, die auf die gemeinsam angeschlossenen Drains aufgebracht wird, eine Injektion von heißen Elektronen in die ausgewählten individuellen schwimmenden Gates versursacht, welche Elektronen einen logischen Zusant speichern, und daß während des gewöhnlichen Speicherzugriffsmodus eine vorbestimmte Spannung auf die gemeinsam verbundenen Steuergates aufgebracht wird, um so ein Auswahlsignal an den gemeinsam verbundenen Drains zu erzeugen, falls das aufgebrachte Muster des Adreßeingangs identisch mit den gespeicherten logischen Zuständen ist.

2. Halbleiterspeichervorrichtung nach Anspruch 1, bei der die vorbestimmte Spannung, zum Aufbringen auf das Steuergate von jedem FAMOS-Transistor während des gewöhnlichen Speicherzugriffsmodus auf Erdpegel oder tiefer gesetzt wird.

3. Halbleiterspeichervorrichtung nach Anspruch 1 oder 2, bei der die Verarmungstyp-FAMOS-Transistoren (41—44) an ihren Sourcen in Reihe mit entsprechenden Gate-Transistoren (31—34), an ihren Elektroden einer Seite, verbunden sind, während die Elektroden der anderen Seite der Gatetransistoren geerdet sind, die Gateelectrokden der Gatetransistoren angeordnet sind, um den Adreßeingang zu empfangen, um so, in Übereinstimmung mit dem Adreßeingang, einige der Gatetransistoren leitend zu machen und andere nichtleitend zu machen.

4. Halbleitervorrichtung nach Anspruch 3, bei der die gemeinsam verbundenen Drains der Verarmungstyp-FAMOS-Transistoren (41—44) während des Schreibbetriebsmodus eine Schreibspannung (V$_{pp}$) und während des gewöhnlichen Speicherzugriffsmodus eine Energiesourcespannung (V$_{cc}$) zu empfangen, zu welcher Zeit die Steuergates der Verarmungstyp-FAMOS-Transistoren eine Spannung empfangen, die Erdpegel hat oder niedriger ist.

5. Halbleitervorrichtung nach Anspruch 4, bei der die Schreibspannung (V$_{pp}$) und die Energiesourcespannung (V$_{cc}$) selektif aud die gemeinsam verbundenen Drains von den Verarmungstyp-FAMOS-Transistoren (41—44) über ein Transistorpaar (25, 26) aufgebracht werden, von denen einer (25) mit einer Schreibspannungssource und der andere (26) mit der Energiesource verbunden ist.

**Revendications**

1. Dispositif de mémoire à semiconducteur comprenant une matrice de cellues de mémoire incluant un ensemble de cellules de mémoire (14); un circuit décodeur (13) qui a accès à une cellule spécifiée des cellules de mémoire (14) selon un signal d'entrée d'adresse; une cellule de redondance (15) qui doit remplacer une cellule de mémoire défectueuse contenue dans la matrice de cellules de mémoire; et un circuit décodeur de redondance (11) qui reçoit le signal d'entrée d'adresse et est actif pour produire un signal de sélection pour sélectionner la cellule de mémoire de redondance quand le signal d'entrée d'adresses reçu spécifie l'adresse correspondant à la cellule de mémoire défectueuse; caractérisé en ce que le circuit décodeur de redondance (11) comprend un ensemble de transistors à métal-oxyde-semiconducteur à injection par avalanche à grille flottante FAMOS (41—44) du type à épuisement qui sont sélectionnées par leurs sources en correspondance avec une configuration du signal d'entrée d'adresse, en ce que, pendant une opération d'écriture, une tension prédéterminée est appliquée aux grilles de commande connectées en commun et en ce que cette tension en combinaison avec une tension d'écriture appliquée aux drains connectés en commun entraîne l'injection d'électrons chauds dans les grilles flottantes individuelles sélectionnées, ces électrons mémorisant un état logique, et en ce que, pendant le mode d'accès à la mémoire courant, une tension prédéterminée est appliquée aux grilles de commande connectées en commun de manière à produire le signal de sélection aux drains connectées en commun si la configuration du signal d'adresses appliqué est identique aux états logiques mémorisés.

2. Dispositif à semiconducteur selon la revendication 1, dans lequel la tension prédéterminée, à appliquer à la grille de commande de chaque transistor FAMOS pendant le mode d'accès à la mémoire courant, est établie pour qu'elle soit au niveau de masse ou à un niveau inférieur.

3. Dispositif à semiconducteur selon l'une quelconque des revendications 1 et 2, dans lequel les transistors FAMOS du type à épuisement (41—44) sont connectés par leurs sources en série avec des transistors de transfert respectifs (31—34), par leurs électrodes d'un côté, alors que les électrodes de l'autre côté des transistors de transfert sont mises à la masse, les électrodes de grille de transistors de transfert étant disposées pour recevoir le signal d'entrée d'adresse de manière à rendre conducteurs certains des transistors de transfert et les autres non conducteurs selon le signal d'entrée d'adresse.

4. Dispositif à semiconducteur selon la revendication 3, dans lequel les drains connectés en commun des transistors FAMOS du type à épuisement (41—44) reçoivent une tension d'écriture (V$_{pp}$) pendant la mode d'opération d'écriture, et une tension de source d'alimentation (V$_{cc}$) pendant le mode d'accés à la mémoire courant où les grilles de commande des transistors FAMOS du type à épuisement reçoivent une tension ayant un niveau de masse ou inférieur.

5. Dispositif à semiconducteur selon la revendication 4, dans lequel la tension d'écriture (V$_{pp}$) et la tension de source d'alimentation (V$_{cc}$) sont appliquées sélectivement aux drains connectés en commun des transistors FAMOS du type à épuisement (41—44) par une paire de transistors (25, 26) dont l'un (25) est connecté à une source de tension d'écriture, et l'autre (26) est connecté à une source d'alimentation.

Fig. 1

Fig. 2

EP 0 098 079 B1

## Fig. 3

## Fig. 4